(19) Europäisches Patentamt
European Patent Office
Office européen des brevets

(11) Publication number: **0 367 555 A2**

(12) **EUROPEAN PATENT APPLICATION**

(21) Application number: **89311221.9**

(22) Date of filing: **31.10.89**

(51) Int. Cl.5 **H04B 1/18 , H01Q 1/12 , H03H 7/40**

(30) Priority: **02.11.88 JP 143591/88 U**
**02.11.88 JP 143592/88 U**

(43) Date of publication of application:
**09.05.90 Bulletin 90/19**

(84) Designated Contracting States:
**BE DE ES FR GB IT SE**

(71) Applicant: **NIPPON SHEET GLASS CO., LTD.**
**5-11, 3-Chome Doshomachi**
**Chuo-ku Osaka(JP)**

(72) Inventor: **Tanaka, Shuhei Nippon Sheet Glass Co., Ltd.**
**5-11, 3-chome Doshomachi Chuo-ku**
**Osaka(JP)**
Inventor: **Murakami, Harunori Nippon Sheet Glass Co., Ltd.**
**5-11, 3-chome Doshomachi Chuo-ku**
**Osaka(JP)**
Inventor: **Baba, Yuji Nippon Sheet Glass Co., Ltd.**
**5-11, 3-chome Doshomachi Chuo-ku**
**Osaka(JP)**

(74) Representative: **Jackson, David Spence et al**
**REDDIE & GROSE 16, Theobalds Road**
**London, WC1X 8PL(GB)**

# (54) Reception system on window glass.

(57) A controllable tuning circuit (24, 140) is provided on a window glass (1) of a motor vehicle and connected to an antenna conductor (23) formed on the glass (1). A feeder cable (25) from the tuning circuit (24) feeds a received signal to a receiver (26) remote from the window glass (1). A control signal (E) according to channel selection information from the receiver (26) is supplied through the signal conductor (25a) of the feeder cable (25) to the controllable tuning circuit (24) to tune it to a selected reception frequency. The control signal (E) determines the impedance of two varactor diodes (34a, 34b) so as to match the cable (25) to the antenna elements (23a, 23b). A diversity reception circuit (144) may additionally be provided on the glass to reduce the number of feeder cables corresponding to a plurality of antenna elements (134, 135) formed on the glass.

**FIG. 6**

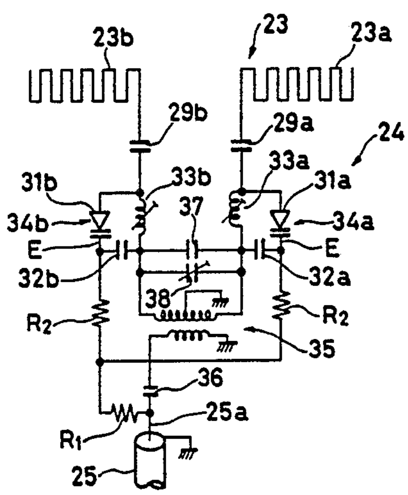


EP 0 367 555 A2

# RECEPTION SYSTEM ON WINDOW GLASS

1. Field of the Invention

This invention relates to a reception system for a motor vehicle and, more particularly, a system using conductors formed on a window glass of the motor vehicle as antenna elements.

2. Description of the Prior Art

A reception system is known wherein antenna conductors are formed on window glass of a motor vehicle to supply a reception signal to an AM radio receiver, an FM radio receiver, a television receiver, and the like mounted in the motor vehicle. In the reception system using such a window glass antenna, a diversity reception system has been employed for supplying to the receiver a received broadcast signal free from change of reception state during travel of the motor vehicle.

Fig. 14 is a front view and a wiring diagram of a rear window glass in which AM, FM, and television broadcast signals are received by a window glass antenna. In this window glass antenna, a large number of heater wires 102 are formed in a defogging area of a rear window glass 101, a heating current is supplied to power supply buses 103 and 104 connected to first ends of the upper and lower groups of the heater wires 102, and a return bus 105 is connected to the second ends of the heater wires 102. Heating current flow through the heater wires 102.

A heating current is supplied to the power supply buses 103 and 104 through a pair of magnetically coupled choke coils 117a and 117b and power supply lines 120 and 121. The choke coil 117a coupled to a main power source +B is negatively coupled to the choke coil 117b coupled to a ground point. Magnetic fluxes generated by heating currents supplied through the choke coils 117a and 117b cancel each other in a core. Therefore, a small-volume core can be operated in a nonsaturated state.

The choke coils 117a and 117b have high impedances with respect to a received high-frequency broadcast wave. A reception signal induced by the heater wires 102 does not leak to a low-impedance power source or ground, and radio wave reception effieicncy can be increased. A decoupling capacitor 122 is coupled to a line connected to the main power source +B to prevent power source noise from being superposed on the reception signal.

An AM/FM antenna 106 is formed in a blank area above the heater wires 102, and an FM antenna 107 is formed in a blank portion below the heater wires 102. Reception signals induced by the antennas 106 and 107 are derived from feeding terminals 106a and 107a, respectively. The signals are supplied to a preamplifier 111 through corresponding feeder cables 108a and 110a such as coaxial cables.

The preamplifier 111 is powered through a power supply line 112 and performs amplification operation at a voltage of DC 12 V. The reception signal amplified by the preamplifier 111 is supplied to an antenna switching circuit 13 through feeder cables 108b and 110b.

The antenna switching circuit 113 switches the antennas used in an FM broadcast band. The antenna switching circuit 13 selects the heigher one in quality of the FM reception signals induced by the antennas 106 or 107. The selected FM reception signal is supplied to the FM receiver through a feeder cable 115. An AM reception signal is supplied to an AM receiver through a feeder cable 114.

TV antennas 123 and 124 are arranged below the heater wires 102. TV reception signals induced by the TV antennas 123 and 124 are respectively supplied to preamplifiers 127 and 128 through feeder cables 125a and 126a. A TV reception signal induced by the heater wires 102 is derived from the power supply bus 103 and is supplied to the preamplifier 127 through a feeder cable 130a and to the preamplifier 128 through a feeder cable 131a.

The TV reception signals amplified by the preamplifiers 127 and 128 are supplied to an antenna switching circuit 132 through corresponding feeder cables 125b and 130b, and 126b and 131b. A TV reception signal having the highest quality is selected by the antenna switching circuit 132 and supplied to a TV receiver.

An intensity of a radio wave received by a glass antenna varies during travel of a motor vehicle from low-intensity reception to high-intensity reception. In a conventional reception system employing the preamplifiers 111, 127 and 128 to improve reception sensibility, problems occur during both low-intensity reception and high-intensity reception.

More specifically, during low-intensity reception, noise level increases by amplification of reception signal and increase of a noise index due to hot noise of the amplifier. It prevents a listener from enjoying clear FM sounds. On the other hand, in a high-intensity reception area such as a location near a broadcasting antenna, the amplifier is saturated to distort voices.

The window glass antenna in Fig. 14 uses two FM antennas and four TV antennas to perform diversity reception for FM and TV broadcast programs. A feed terminal is arranged at each antenna, and each reception signal is derived from the corresponding feed terminal. In order to obtain AM/FM broadcast and TV broadcast reception signals, the six feeder cables 108a, 110a, 125a, 126a, 130a, and 131a must be connected on the rear window glass 101.

Wiring around the window is complicated due to many feeder cables and a wiring works are cumbersome. Wirings such as signal lines and power supply lines must be arranged along the edge of the rear window glass 101, and preamplifies must be arranged near the rear window glass 101. If the wirings are externally exposed, it results in poor appearance.

## SUMMARY OF THE INVENTION

It is a primary object of this invention to provide a high-gain reception system of a motor vehicle without using a preamplifier.

It is another object of this invention to change matching state between an antenna element and a feeder cable in accordance with a reception channel to reduce transmission loss of a reception signal fed from the antenna to the receiver, for improving a reception sensibility.

It is still another object of this invention to reduce the number of feeder cables required to connect a plurality of antenna elements on a window glass of the motor vehicle to a receiver for composing a diversity reception system.

A reception system according to the present invention comprises an antenna conductor and an electronic tuning circuit to be tuned to a reception frequency on the basis of channel selection information supplied from a receiver. The antenna conductor and the electronic tuning circuit are formed on a window glass surface of a motor vehicle.

According to one aspect of this invention, the electronic tuning circuit is a controllable impedance circuit serving as a matching circuit between the antenna conductor and a feeder cable extending to the receiver. Since the impedance control circuit is arranged on the glass surface to be coupled directly with the antenna conductor, impedance control range corresponding to reception bandwidth is small, resulting in good controllablity.

When the impedance control is performed on the basis of the channel selection information supplied from the receiver, loss in gain of the reception signal to be fed to the receiver can be reduced to improve a reception gain.

According to another aspect of this invention, the electronic tuning circuit is a tuner circuit having at least an RF stage which receives the channel selection information and is tuned to selectively output a signal with a reception frequency corresponding to the channel selection.

According to still another aspect of this invention, a reception system further comprises a plurality of antenna conductors and a diversity reception circuit which receives the reception signals induced by the plurality of antenna conductors and forms a diversity reception signal to be fed to a receiver on a motor vehicle. The antenna conductors and the diversity reception circuit are formed on a window glass surface.

The diversity reception circuit on the window glass forms single diversity-synthesized signal on the basis of signals induced by the plurality of antenna conductors. The number of output terminals on the window glass can be greatly reduced as well as the number of feeder cables to be connected to the rear window glass.

These and other objects of the invention will be seen by reference to the description, taken in connection with the accompanying drawing, in which:

Fig. 1 is a front view of a rear window glass of a motor vehicle and a circuit diagram showing an embodiment of the present invention;

Fig. 2 is a block diagram of an FM reception system;

Fig. 3 is a segmentary view showing conductor pattern of an FM antenna element;

Fig. 4 is a Smith chart showing impedance characteristics tested at a remote position from the antenna;

Fig. 5 is a Smith chart showing impedance characteristics tested at a position near the antenna;

Fig. 6 is a circuit diagram of an electronic tuning circuit;

Fig. 7 is a graph showing reception sensibility when the receiver is turned to 80 MHz;

Fig. 8 is a view showing a modification of an antenna conductor pattern;

Fig. 9 is a front view and a circuit diagram of a rear window glass according to the second embodiment of the present invention;

Fig. 10 is a block diagram of a diversity reception system;

Fig. 11 is a circuit diagram of a diversity reception circuit;

Fig. 12 is a block diagram of an arrangement in which tuners are formed on the window glass surface;

Fig. 13 is a block diagram showing a further modification of Fig. 12; and

Fig. 14 is a front view and a circuit diagram of a rear window glass employing a conventional reception system for a motor vehicle.

## DETAILED DESCRIPTION OF A PREFERRED EMBODIMENT

Fig. 1 is a front view and a wiring diagram of a rear window glass in a reception system for a motor vehicle. A heating conductor 2 is formed in a defogging area of a rear window glass 1. The heating conductor 2 includes a number of heater wires 7 extending in the horizontal direction of the defogging area and power supply buses 10 and 11 at both ends of the heater wires 7. A power supply circuit to the heater wires 7 is the same with that of Fig. 14.

An AM reception signal induced by the heating conductor 2 is derived from a feed point 12 to an LC matching circuit 15 through a DC cutoff capacitor 14. The reception signal is then supplied to an AM radio receiver 16 through a feeder cable 13 such as a coaxial cable.

An FM radio program is received by an FM reception system shown in Fig. 2. An FM reception signal $S_1$ induced by the FM antenna conductor 23 is supplied to an electronic tuning circuit 24 and is then supplied therefrom to an FM radio receiver 26 through a coaxial feeder cable 25. An FM audio signal $S_2$ demodulated by the radio receiver 26 is supplied to a speaker 27.

The FM antenna conductor 23 comprises a balanced conductor. Fig. 1 shows upper and lower FM antenna elements 23a and 23b of identical shapes formed symmetrically in an upper blank area of the heating conductor 2 on a glass surface. In a pattern of each of the FM antenna elements 23a and 23b shown in Fig. 3, a plurality of indentations 30 are formed to provide an inductive antenna element. Indentation pitches $\ell_1$, heighits $\ell_2$ and widths $\ell_3$ of the indentations 30 are adjusted to tune the antenna to the FM broadcast band.

The electronic tuning circuit 24 is attached on the rear window glass 1 to be directly coupled to the FM antenna conductor 23 and serves as a controllable impedance circuit. The closer the electronic tuning circuit 24 is arranged to the FM antenna conductor 23, the more impedance control can be facilitated. Antenna impedance for reception frequencies varies by about one revolution on a Smith chart as indicated in Fig. 4 at a location near the input of FM radio receiver 26 which is connected to the FM antenna conductor 23 through a long feeder cable. For example, when impedance is controlled by changing a capacitance of a variable capacitor, a varying range of the capacitance is too wide to perform impedance matching control in the entire reception frequency band.

At the output of FM antenna conductor 23, antenna impedance varies by 1 4 revolution or less for the reception frequencies, as indicated by a solid characteristic curve A in the Smith chart of Fig. 5 so that impedance matching control in the entire FM broadcast band can be facilitated.

The electronic tuning circuit 24 for impedance matching control is an integral unit constituted by a hybrid IC. As shown in the circuit diagram of Fig. 6, the electronic tuning circuit 24 includes a pair of controllable impedance circuits 34a and 34b which receive outputs through DC cutoff capacitors 29a and 29b from the FM antenna elements 23a and 23b arranged in opposite phases on the glass surface. Outputs from the controllable impedance circuits 34 are supplied to a balancing circuit 35, and balanced outputs are converted into an unbalance signal which is then supplied to the FM radio receiver 26 through the feeder cable 25.

The controllable impedance circuit 34a (34b) comprises a series circuit of a varactor diode 31a (31b) and a tuning capacitor 32a (32b), and a tuning coil 33a (33b) connected in parallel with this series circuit. The controllable impedance circuits 34a and 34b control their line impedance viewed from the feeder cable 25 on the basis of channel selection information supplied from the FM radio receiver 26.

As indicated by a broken characteristic curve B in Fig. 5, the impedance viewed from the feeder cable 25 can be controlled by the impedance control circuits 34a and 34b so that an impedance represented by a point P is obtained at a given reception frequency. The impedance of the point P is the same as the characteristic impedance of the feeder calble 25, i.e., 50 Ω ± J0.

In this embodiment, in order to set the impedance viewed from the feeder cable 25 to be 50 Ω even if a reception channel is changed, the control voltage E applied to the anode of the varactor diode 31 is changed in correspondence with the reception channel. Inductance components of the antenna elements 23a and 23b at a given frequency are cancelled with controlled capacitance of the varactor diodes 31a and 31b.

The control voltage E is generated by the FM radio receiver 26 as a DC voltage corresponding to the reception channel and is supplied to the signal line 25a of the feeder cable 25. As shown in Fig. 6, the control voltage E is extracted from the signal line 25a through a resistor R1. The voltage is then applied to the anode of the varactor diodes 31a and 31b through resistors R2. A reception signal is derived through the balancing circuit 35 and a DC cutoff capacitor 36 to the signal line 25a. Resonance capacitors 37 and 38 are connected across a primary winding of the balancing circuit 35.

The capacitance of the varactor diode 31 can be changed in correspondence with the reception channel. Even if the reception channel is changed, the impedance of the antenna-side circuit can be controlled to be 50 Ω . The resistance of the resistor R1 need not be sufficiently high, e.g., 10 kΩ, while the resistance of the resistors R2 are set to be sufficiently high, e.g., about 100 kΩ. Therefore, the DC control voltage E can be applied to the controllable impedance circuits 34a and 34b, and the reception signal does not leak from each of controllable impedance circuits 34a and 34b to the signal line 25a.

In the glass antenna of this embodiment, the impedance of the glass antenna can be always matched with that of the feeder cable 25 regardless of changes in reception frequency, and the reception signal can be supplied to the FM radio receiver with low loss in gain. For this reason, the reception sensibility can be greatly increased, and a high-sensibility FM broadcast reception system can be built up without using a preamplifier. As shown in a graph of reception sensitivity in Fig. 7, a conventional glass antenna has almost flat sensibility characteristics in the entire FM broadcast band from 76 to 90 MHz, as indicated by a broken characteristic curve A. To the contrary, in the glass antenna of this embodiment, a gain appears only at a reception frequency, as indicated by a solid characteristic curve B when, e.g. a program from an 80 MHz FM broadcast station is received. Therefore, frequency selection can be performed on the glass surface, and signal interference can be greatly reduced.

In the above embodiment, the upper and lower FM antenna elements 23a and 23b are symmetrically arranged. However, right and left antenna elements may be symmetrically arranged with each other, as shown in a pattern chart of Fig. 8. If the balanced antenna is used, no adjustment is required depending on different vehicle models. The antenna conductor may be an unbalanced conductor. In this case, the electronic tuning circuit comprises a single-sided controllable impedance circuit.

The present invention may be used in a television broadcast band or a telephone signal band in addition to the FM radio broadcast band.

As mentioned above, a controllable impedance circuit is arranged on the same glass surface as that with the antenna conductor. The impedance of the impedance circuit is remotely adjusted in response to channel selection information from a receiver. Antenna impedance is matched with a feeder cable to be extended to the receiver. This remote control system provides a good controllability of the impedance matching operation over a wide range of tuning frequency. Losses of the reception signal within a path from the antenna to a receiver is greatly reduced, thus improving reception sensibility. A high-gain reception system without a preamplifier can be arranged, and drawbacks such as noise interference in a low-intensity broadcasting area and voice distortion in a high-intensity broadcasting area can be eliminated.

Fig. 9 is a front view and a wiring diagram of a rear window glass according to a second embodiment of the present invention. The heating conductor pattern and the heating current supply circuit of the rear window glass 101 are the same as those in Fig. 14.

In this embodiment, an AM/FM antenna 134 and an FM antenna 135 are formed in a blank portion above heater wires 102. First and second TV atnennas 136 and 137 are formed in a blank portion below the heater wires 102.

The antennas 134 to 137 comprise balanced antenna elements. That is, pairs of upper and lower antenna elements 134a and 135b, 135a and 135b, 136a and 136b, and 137a and 137b having identical patterns are arranged symmetrically on the glass surface, as shown in Fig. 9.

A pattern of each of the antenna elements may have the same configuration with that shown in Fig. 3.

Reception signals induced by the antennas 134 to 137 are supplied to signal processing circuits 140 and 141 arranged at the center of upper and lower blank areas of the rear window glass 101. The signal processing circuits 140 and 141 are constituted by hybrid ICs each including a pair of electronic tuning circuits 143a and 143b and one diversity reception circuit 144. The electronic tuning circuits 143a and 143b may be identical with that shown in Fig. 6. The diversity reception circuit 144 selects an excellent one from FM reception signals derived from the output lines 148a and 148b of the electronic tuning circuits 143a and 143b respectively corresponding to the antennas 134 and 135.

As shown in Fig. 10, in the AM/FM reception signal processing circuit 140, an FM cutoff coil $L_2$ - (3 to 5 μH) is inserted in a signal line 148a for supplying the AM reception signal to a feed point 147. An AM cutoff capacitor $C_2$ (5 to 10 pF) is inserted in a signal line 148c for supplying the FM reception signal to the diversity reception circuit 144. The FM reception signal is not supplied to the feed point 147 through the signal line 148a. Only an FM reception signal transmitted through the diversity reception circuit 144 is supplied to the feed point 147 through a signal line 48d.

A resistor $R_3$ having a large resistance (e.g., 100 kΩ) is connected to the signal line 148d, and the DC control voltage E is applied to the electronic tuning circuits 143a and 143b through the

resistor $R_3$. A bypass capacitor $C_3$ (5 to 10 pF) is connected in parallel with the resistor $R_3$ for bypassing the FM reception signal.

Diversity reception is performed by the TV broadcast signal processing circuit 141 in the same manner as described above. More specifically, TV reception signals induced by the first and second TV antennas 136 and 137 are supplied to the diversity reception circuit 144 through the electronic tuning circuits 143a and 143b, and the selected TV signal is supplied to a TV signal feed point 149.

An arrangement of the diversitiy reception circuit 144 is shown in Fig. 6. Two antenna reception signals Sa and Sb supplied via the signal lines 148a and 148b are supplied to a level comparator 150 and a high-frequency distortion detector 151 through resistors R6 and R7. A level signal output from the level comparator 150 and a distortion detection signal from the high-frequency distortion detector 151 are supplied to a signal selector 152. The signal selector 152 forms ON/OFF control signals to PIN diodes 164 and 165 arranged in lines for outputting the reception signals Sa and Sb in accordance with the input signals. One of the PIN diodes 164 and 165 turns on to output a reception signal having a higher level and a lower high-frequency distortion component. The ON/OFF states of the PIN diodes 164 and 165 are changed over whenever one of the reception levels turns to high and one of the high-frequency distortions turns to low. Therefore, a high-quality reception signal is output.

The control voltage E is transmitted through resistors R4 and R5 respectively connected in parallel with the corresponding PIN diodes 164 and 165. The diversity reception circuit may be replaced with another circuit which performs diversity reception by counting, e.g., the number of noise signals.

The AM/FM and TV reception signals respectively supplied to the feed points 147 and 149 are respectively derived through feeder cables 154 and 155, and the derived signals are supplied to the AM/FM and TV receivers, as shown in Figs. 9 and 10. In this embodiment, the four antennas 134 to 137 are formed on the rear window glass 101. The antenna outputs are diversity-sythesized on the window glass 101, so that the signals received by the four antennas can be derived only through two feeder cables 154 and 155. Therefore, the number of feeder cables to be connected on the window glass can be greatly reduced. The wiring works of the feeder cables can be simplified, and at the same time, the number of cables extending along the edge of the window glass 101 can be reduced, which simplifies the peripheral portion of the window glass.

Fig. 12 is a block diagram showing an arrangement in which AM and FM tuner circuits are arranged on the surface of the rear window glass 101. In the signal processing circuit 140, an AM tuner 157 is arranged in the signal line 148a for supplying the AM reception signal to the feed point 147. An FM tuner 158 is inserted in the signal line 148d for supplying the FM reception signal supplied from the diversity reception circuit 144 to the feed point 147.

The AM and FM turners 157 and 158 include at least RF stages, and the AM and FM reception signals from the antennas 134 and 135 are tuned on the surface of the rear window 101.

The signals of AM and FM broadcast frequencies output from the tuners 157 and 158 are supplied to the feed point 147.

The feed point 147 is connected to an AM/FM radio receiver 160 through a multicore feeder cable 161. The multicore feeder calbe 161 comprises a 4-core cable whose covering is grounded. The AM/FM reception signal supplied to the feed point 147 is supplied to the AM/FM radio receiver 60 through an RF signal line 161a. Reception channel information is supplied from the AM/FM radio receiver 160 to the AM and FM tuners 157 and 158 through a control line 161b. An AGC voltage and a power supply voltage are supplied from the AM/FM radio receiver 160 to the tuners 157 and 158 through an AGC signal supply line 161c and a power supply line 161d, respectively. The reception channel information may be supplied through the RF signal line 161a.

Antenna impedance matching control, diversity composition, tuning, and the like are performed on the window glass surface. Therefore, the reception sensibility can be further increased, and the transmission loss of the reception signal can be further reduced.

Fig. 13 shows a further modification of the circuit of Fig. 12. In this modification, an AM tuner 157, an FM tuner 158 and a diversity reception circuit 140 are attached on the surface of the rear window glass 101 in the same manner with the arrangement of Fig. 12. The electronic tuning circuits 143a and 143b in Fig. 12 are removed. The AM tuners 157 is directly coupled to the AM/FM antenna 134. The FM tuner 158 is connected to the output of the diversity reception circuit 144 of which inputs are coupled directly to the antennas 134 and 135.

According to the present invention as described above, the plurality of antenna conductors and the diversity reception circuit are arranged on the window glass, and a diversity reception signal is formed on the glass surface from the reception signals induced by the plurality of antenna conductors. As compared with a case wherein each reception signal induced by each antenna conductor is transmitted, the number of feeder cables to be connected to the window glass can be greatly reduced. Wiring works can be facilitated, and the peripheral portion of the window glass can be simplified.

## Claims

1. A reception system for a motor vehicle having
an antenna conductor formed on a window glass of said motor vehicle and a feeder cable for feeding a reception signal to a receiver at a remote location characterized by comprising:
a controllable impedance circuit (34a, 34b) arranged on said window glass and having an input coupled to said antenna conductor (23a, 23b);
said feeder cable (25) being connected to an output of said controllable impedance circuit; and
said controllable impedance circuit being supplied with a control signal (E) according to channel selection from said receiver (26) so that the impedance thereof is controlled to match with the characteristic impedance of the feeder cable.

2. A reception system according to claim 1, characterized in that said controllable impedance circuit (34a, 34b) comprises a resonance circuit consisting of an inductance element (33a, 33b) and a capacitance element (34a, 34b), said capacitance element being a controllable capacitor element controlled in accordance with the control signal (E).

3. A reception system according to claim 2, characterized in that said antenna conductor comprises a pair of antenna elements (23a, 23b), and said controllable impedance circuit (34a, 34b) comprises a pair of resonant circuits connected to respective antenna elements and a blancing circuit (35) connected to the pair of resonant circuits to receive a pair of balanced signals therefrom, said balanced signals being converted by the balancing circuit to a single unbalanced signal to be fed to said feeder cable (25).

4. A reception system according to claim 3, characterized in that said pair of antenna elements (23a, 23b) are symmetrically arranged in horizontal direction.

5. A reception system according to claim 3, characterized in that said pair of antenna elements are symmetrically arranged in vertical direction.

6. A reception system according to any one of claims 3 to 5, characterized in that said antenna conductor comprises antenna wire having a plurality of vertical indentations (30).

7. A reception system according to claim 1, characterized in that said antenna conductor and said controllable impedance circuit comprise at least two antenna elements (134, 135) and controllable impedance circuits (143a, 143b) respectively coupled to said antenna elements, and
said system further comprises a diversity reception circuit (144) having input terminals coupled to the outputs of said controllable impedance cirucits (143a, 143b) and a single output terminnal coupled to said feeder cable (25) to derive an excellent one of reception signals induced on said antenna elements.

8. A reception system according to claim 7, characterized in that said diversity reception circuit (144) comprises:
a level comparator (150) receiving said outputs of said controllable impedance circuits (143a, 143b), comparing amplitude levels of said outputs and deriving a selection signal, and
a selector means (164, 165) to select a heigher one in level of reception signals from said impedance circuits in response to said selection signal.

9. A reception system according to claim 8, characterized in that said diversity reception circuit (144) further comprises:
a high frequency distortion detecting circuit (151) receiving said outputs of said controllable impedance circuits (143a, 143b), detecting increase of distortion of said reception signals and deriving a detection signal, and control means (152) to control said selector means (164, 165) in response to said selection signal and said detection signal.

10. A reception system according to claim 7, characterized in that one of said antenna elements (134, 135) is used for AM broadcast wave reception and for FM broadcast wave rèception; and
an output line of said controllable impedance circuit (143a) of said FM/AM antenna element divaricates into two branches;
one of the branches including an inductance element $L_2$ to pass the AM broadcast wave to said feeder cable (154) and to cut off the FM broadcast wave,
another one of the branches incuding a capacitance element ($C_2$) to pass the FM broadcast wave to said diversity reception circuit (144) and to cut off the AM broadcast wave, and
the FM broadcast wave at the output of said diversity reception circuit being fed to said feeder cable (154) to be mixed with the AM broadcast wave.

11. A reception system for a motor vehicle having
an antenna conductor formed on a window glass of said motor vehicle and a feeder cable for feeding a reception signal to a receiver at a remote location characterized by comprising:
an electronic tuning circuit (140, 141) arranged on said window glass and having an input coupled to said antenna conductor (134, 135);
said feeder cable (161) being connected to an output of said electronic tuning circuit: and said electronic tuning circuit being supplied with a control signal according to channel selection from said rerceiver (160) so that the electronic tuning circuit is tuned to a frequency corresponding to said channel selection.

12. A reception system according to claim 11, characterized in that said electronic tuning circuit comprises a tuner circuit (157, 158) including at least an RF stage which is supplied with said control signal and is tuned to selectively output a signal with a reception frequency corresponding to said channel selection.

13. A reception system according to claim 12, characterized in that said electronic tuning circuit further comprises a controllable impedance circuit (143a, 143b) having an input coupled to said antenna conductor (134, 135) and an output coupled to the input of said tuner circuit (157, 158), said controllable impedance circuit being supplied with said control signal so that the impedance thereof is controlled to match with said tuner circuit.

14. A reception system according to claim 11, characterized in that said antenna conductor comprises at least two antenna elements (134, 135); and said system further comprises a diversity reception circuit (144) having inputs coupled to said antenna elements and a single output coupled to the input of said electronic tuning circuit (158) to derive thereto an excellent one of reception signals induced on said antenna elements.

FIG. 1

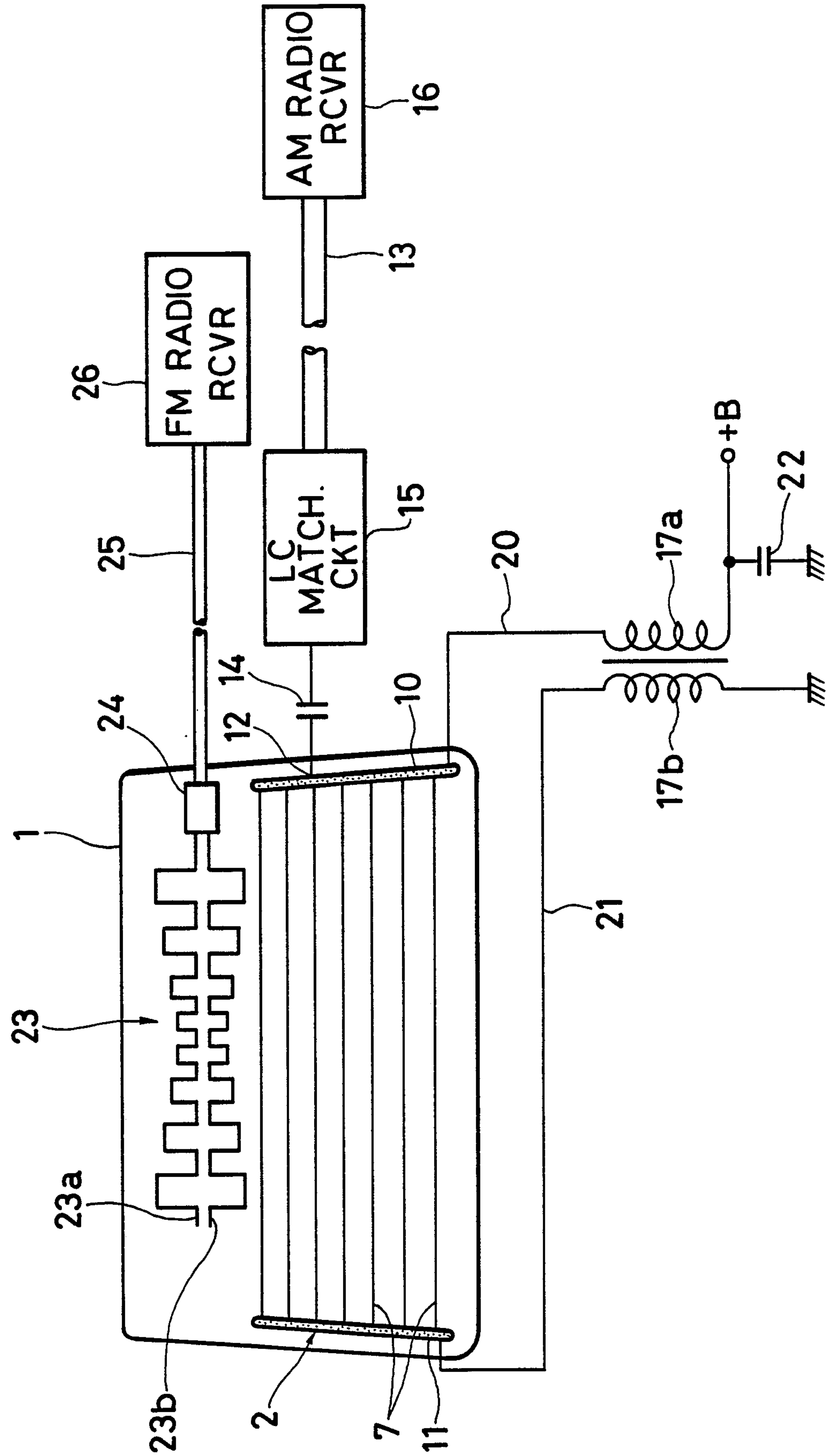
AM RADIO RCVR
16
13
FM RADIO RCVR
26
25
LC MATCH. CKT
15
+B
22
20
17a
14
10
24
12
17b
1
21
23
23a
23b
2
7
11

F I G. 2

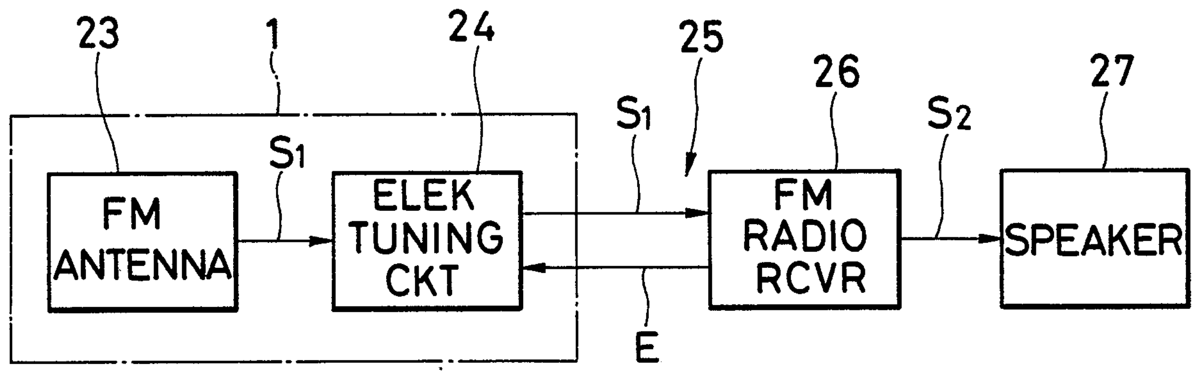
23
1
24
25
26
27
S1
S1
S2
FM
ANTENNA
ELEK
TUNING
CKT
FM
RADIO
RCVR
SPEAKER
E

F I G. 3

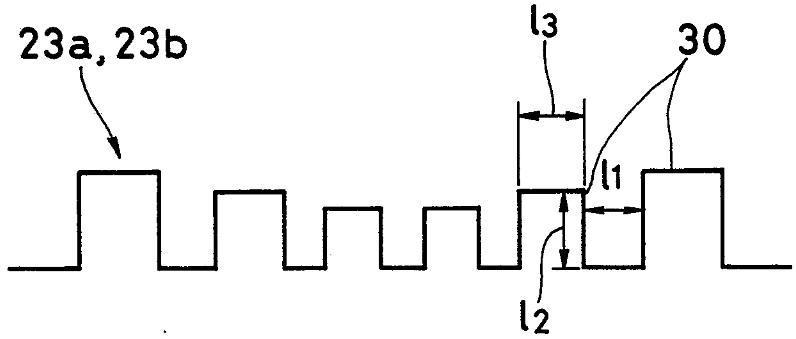
23a, 23b
l3
30
l1
l2

# FIG. 4

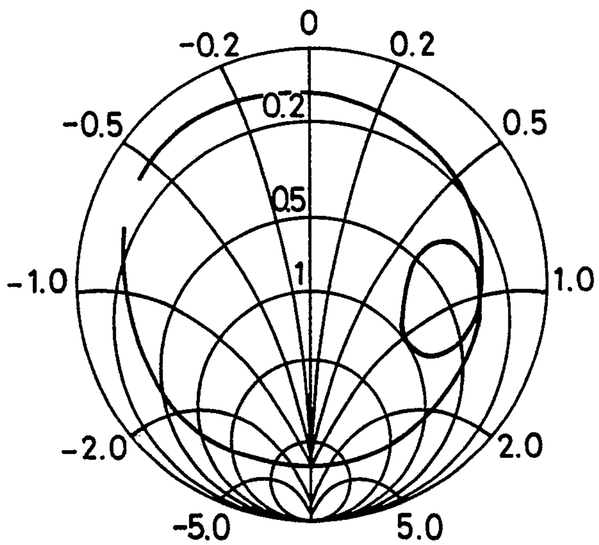
0
-0.2
0.2
-0.5
0.5
0.2
0.5
1
-1.0
1.0
-2.0
2.0
-5.0
5.0

# FIG. 5

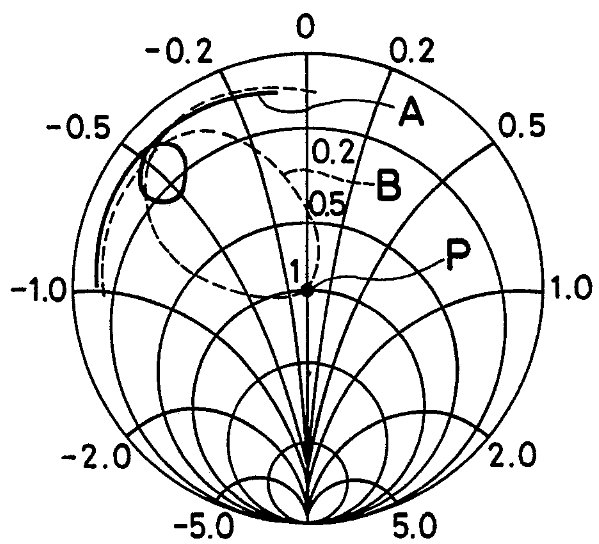
0
-0.2
0.2
A
-0.5
0.5
0.2
B
0.5
P
1
-1.0
1.0
-2.0
2.0
-5.0
5.0

FIG.6

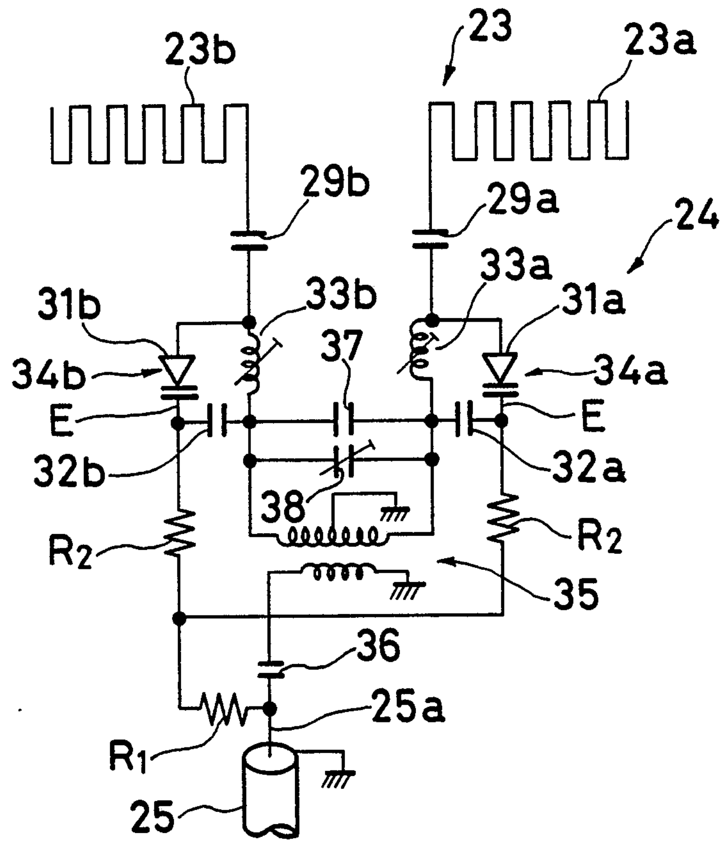


FIG.7

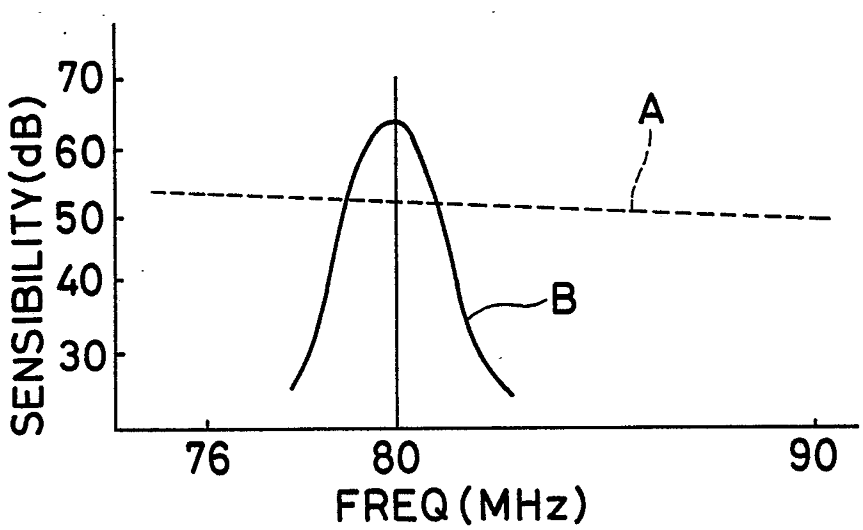


FIG.8

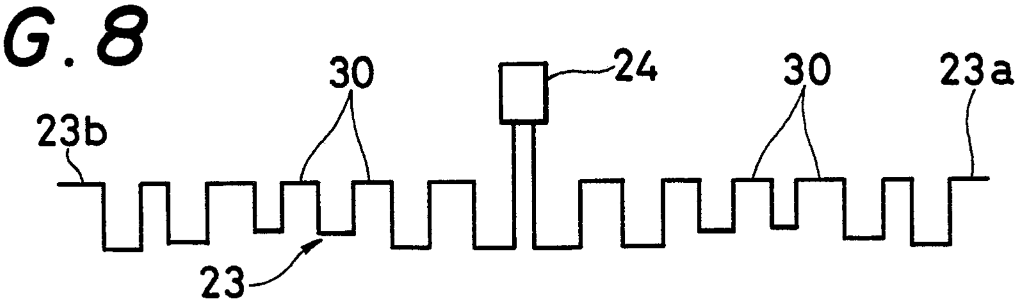

FIG. 9

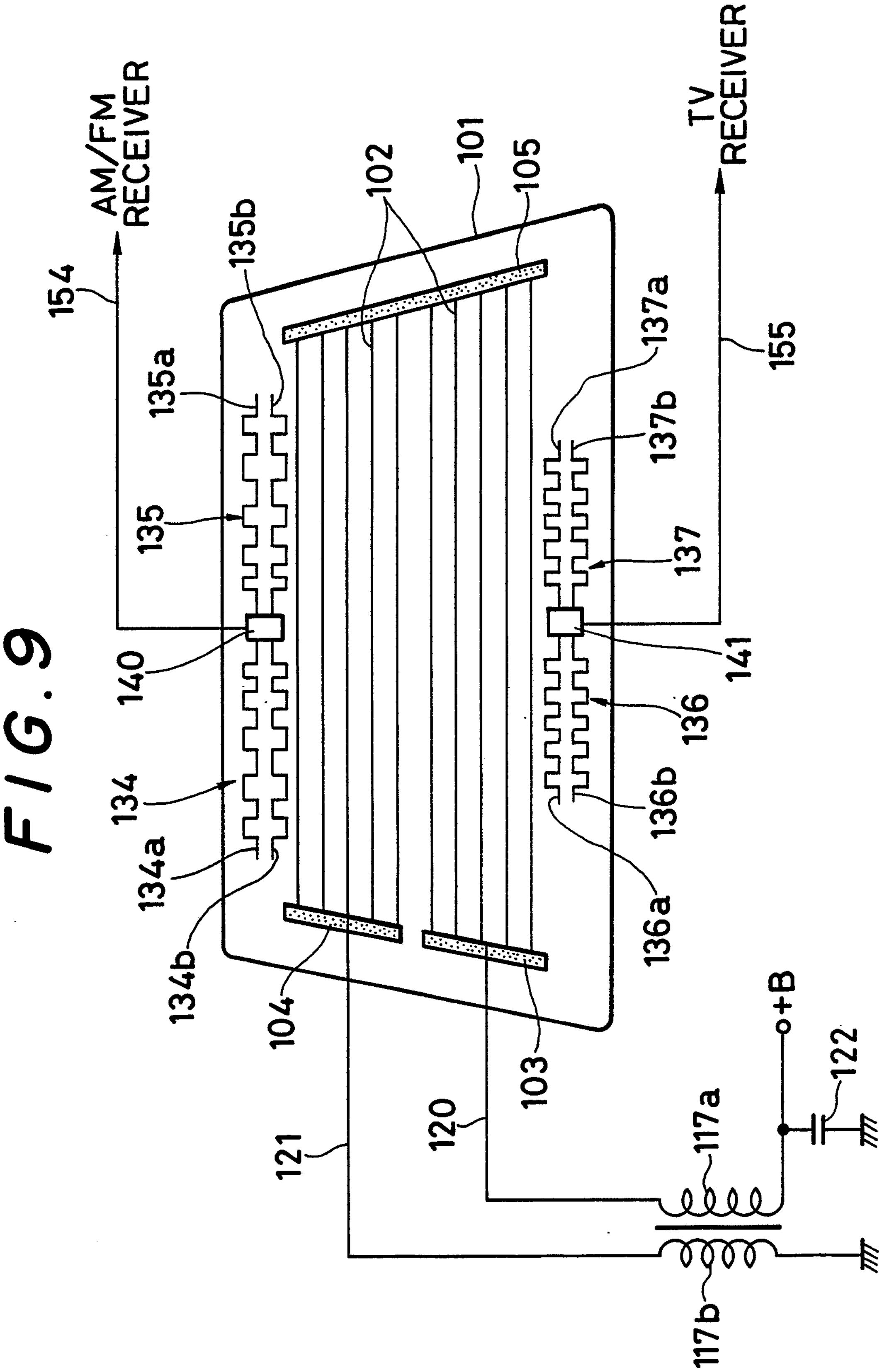
AM/FM RECEIVER
TV RECEIVER
154
155
101
102
103
104
105
134
134a
134b
135
135a
135b
136
136a
136b
137
137a
137b
140
141
117a
117b
120
121
122
+B

FIG. 10

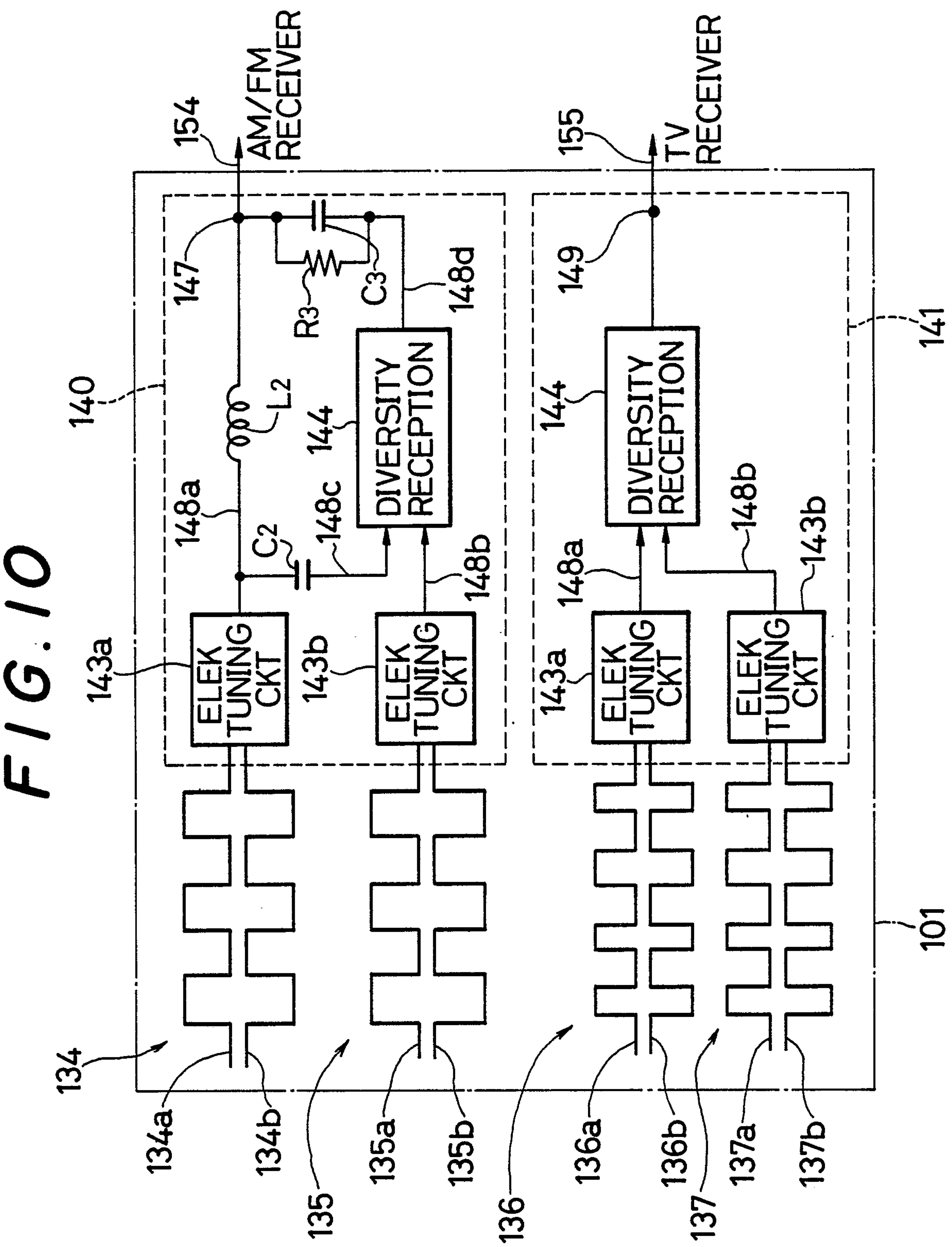
AM/FM RECEIVER
TV RECEIVER
154
155
147
149
C3
R3
L2
C2
148a
148b
148c
148d
140
141
144
DIVERSITY RECEPTION
DIVERSITY RECEPTION
143a
143b
ELEK TUNING CKT
ELEK TUNING CKT
ELEK TUNING CKT
ELEK TUNING CKT
101
134
134a
134b
135
135a
135b
136
136a
136b
137
137a
137b

FIG. 11

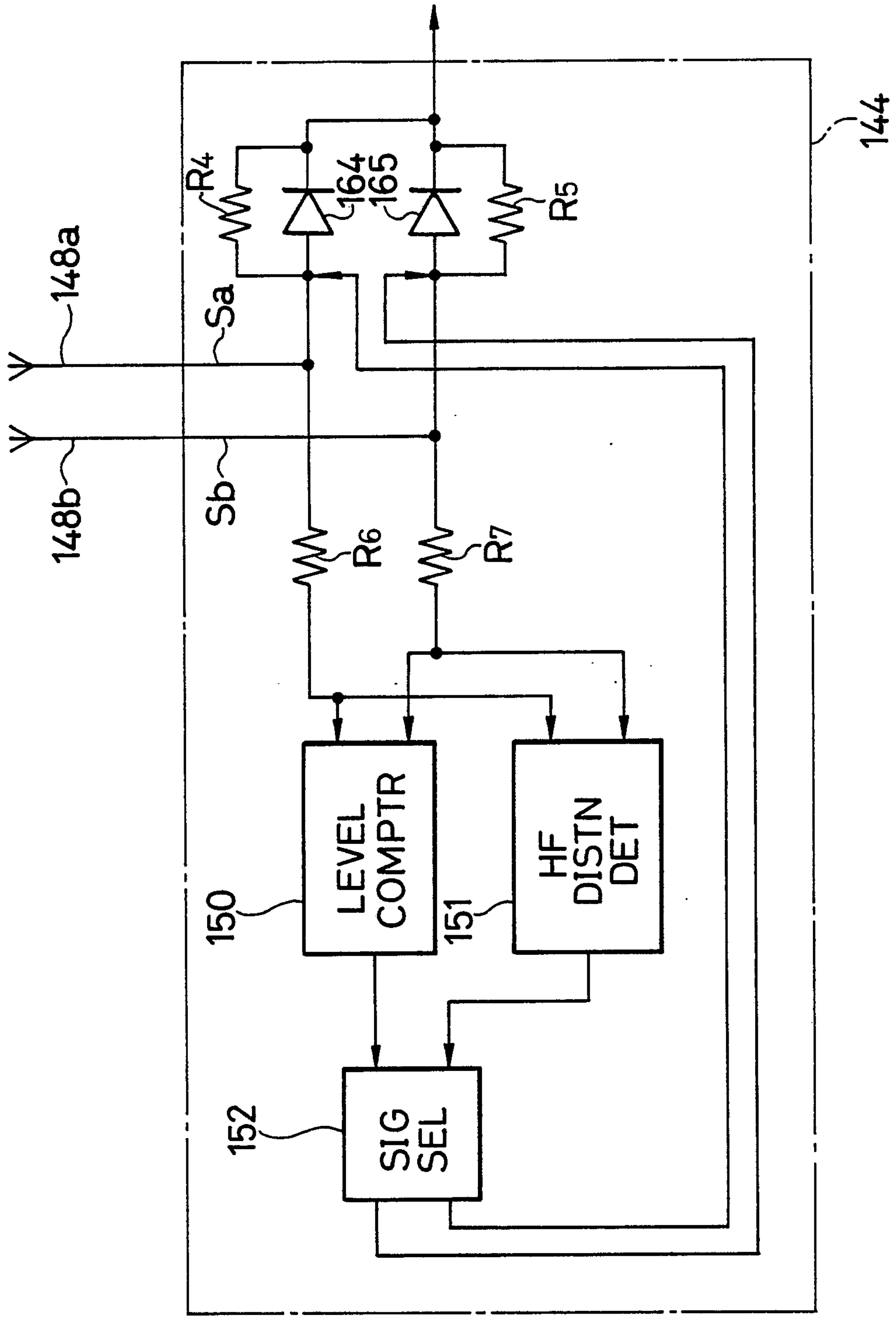

148a
148b
Sa
Sb
R4
R5
R6
R7
164
165
144
150
LEVEL COMPTR
151
HF DISTN DET
152
SIG SEL

FIG.12

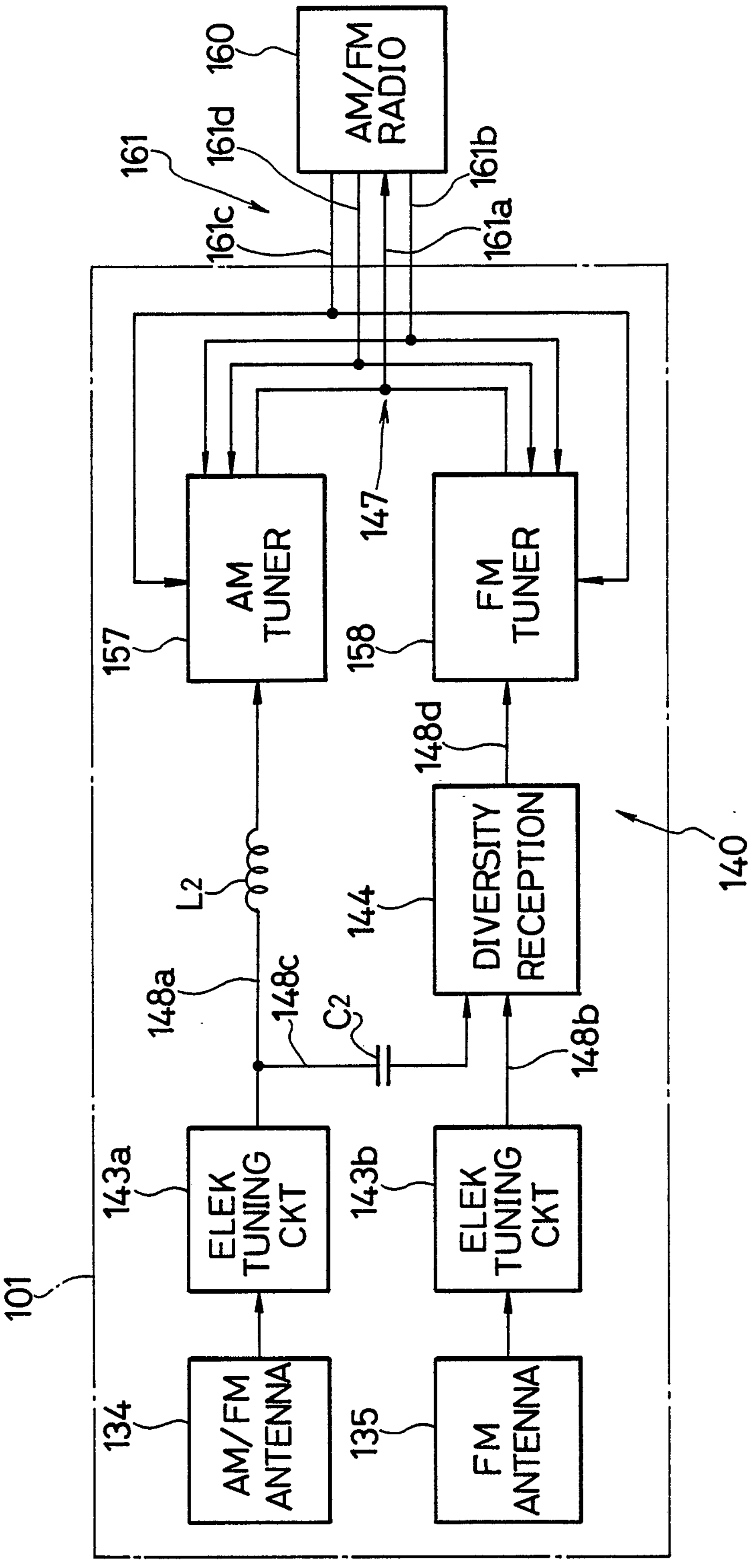
AM/FM RADIO
160
161
161a
161b
161c
161d
AM TUNER
157
FM TUNER
158
147
148a
148b
148c
148d
L2
C2
DIVERSITY RECEPTION
144
140
ELEK TUNING CKT
143a
143b
101
AM/FM ANTENNA
134
FM ANTENNA
135

FIG.13

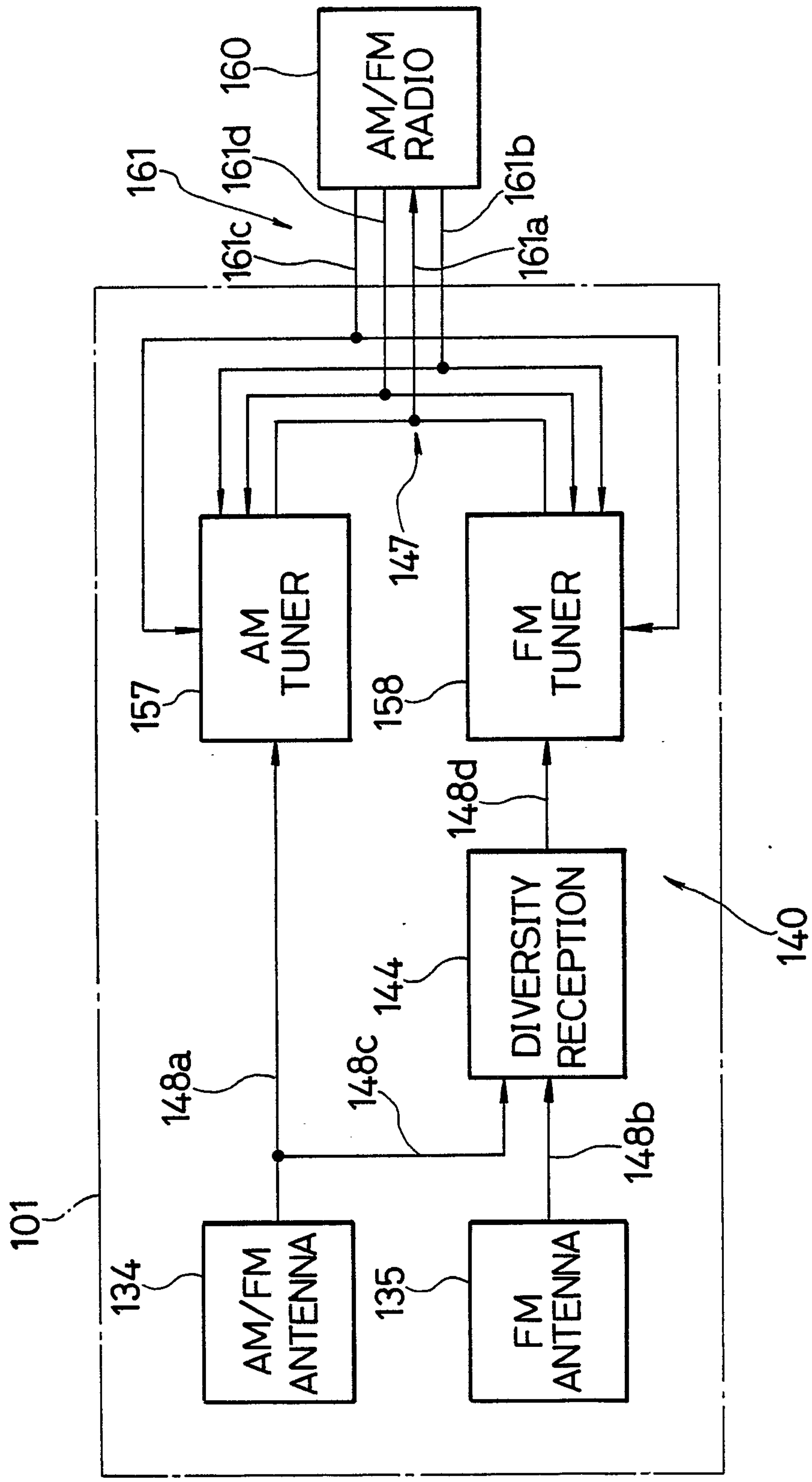
AM/FM RADIO
160
161
161a
161b
161c
161d
AM TUNER
157
FM TUNER
158
147
DIVERSITY RECEPTION
144
140
148a
148b
148c
148d
AM/FM ANTENNA
134
FM ANTENNA
135
101

FIG. 14

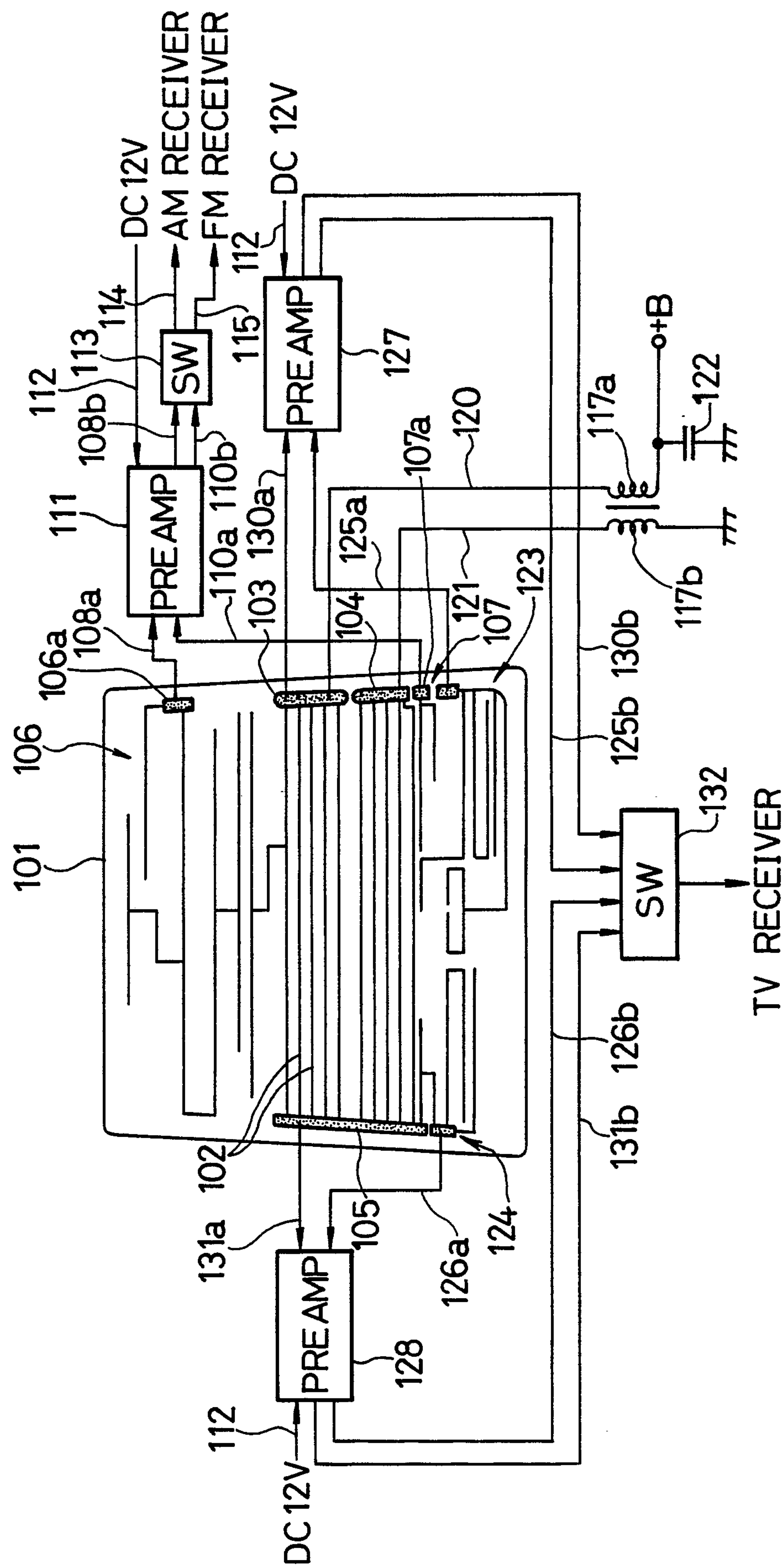
DC 12V
AM RECEIVER
FM RECEIVER
DC 12V
SW
PRE AMP
PRE AMP
PRE AMP
SW
TV RECEIVER
DC 12V
+B
101
102
103
104
105
106
106a
107
107a
108a
108b
110a
110b
111
112
113
114
115
117a
117b
120
121
122
123
124
125a
125b
126a
126b
127
128
130a
130b
131a
131b
132